# FASCICULE DE BREVET EUROPEEN

(11) **EP 0 600 788 B1**
(45) Date de publication et mention de la délivrance du brevet: **21.01.1998**
(21) Numéro de dépôt: 93402899.4
(22) Date de dépôt: 30.11.1993
(51) Int. Cl.: H03M 1/14, H03M 1/34

(54) **Convertisseur analogique numérique**
Analog-Digitalumsetzer
Analog-digital converter

(30) Priorité: 04.12.1992 FR 9214640
(43) Date de publication de la demande: 08.06.1994
(73) Titulaire: THOMSON-CSF SEMICONDUCTEURS SPECIFIQUES, 75008 Paris (FR)
(72) Inventeur: Wingender, Marc, F-92402 Courbevoie Cédex (FR); Le Tual, Stéphane, F-92402 Courbevoie Cédex (FR)
(74) Mandataire: Guérin, Michel

(56) Documents cités:
- EP-A- 0 227 165
- EP-A- 0 302 553
- EP-A- 0 414 389
- WO-A-92/08288
- US-A- 4 058 806

## Description

L'invention concerne les convertisseurs analogiques numériques c'est-à-dire les circuits électroniques capables de convertir un signal d'entrée analogique en une valeur numérique précise représentant l'amplitude du signal analogique. La valeur numérique est obtenue sous forme d'un mot de plusieurs bits, en général codé en binaire pur.

Plusieurs procédés de conversion existent, et le choix d'un procédé plutôt qu'un autre dépend des performances que l'on attend du convertisseur. Les paramètres les plus importants de ces performances sont :
- la résolution, définie par le nombre de bits du mot de sortie représentant avec exactitude l'amplitude du signal analogique ; le nombre de bits peut être de 16 à 18, voire même 20, pour les convertisseurs les plus précis, et la précision est en général de + ou - 1/2 bit de poids le plus faible ;
- la rapidité, c'est-à-dire le nombre d'opérations de conversion qu'on peut effectuer en une seconde;
- la consommation de puissance : un convertisseur rapide et précis consomme beaucoup plus d'énergie qu'un convertisseur lent et peu précis ; or la consommation de puissance entraîne un échauffement de la puce de circuit-intégré sur laquelle est réalisé le convertisseur. Cet échauffement doit être compensé par des moyens de refroidissement qui rendent le circuit difficilement utilisable lorsqu'il y a des contraintes d'encombrement à respecter;
- et bien sûr le coût de conception et de fabrication du convertisseur, lié en particulier à la surface de puce de circuit intégré utilisée par le convertisseur.

Les qualités d'un convertisseur analogique-numérique résultent d'un compromis entre les paramètres ci-dessus et un but de la présente invention est d'améliorer ce compromis.

Parmi les structures connues de convertisseurs analogiques-numériques, on peut citer :
- les convertisseurs à approximations successives, qui comparent le signal analogique d'entrée Vin successivement à des valeurs numériques approchant à chaque fois un peu mieux la valeur du signal analogique ; ces convertisseurs fonctionnent en au moins N phases si la valeur est codée sur N bits ; ils sont donc en général très lents pour des précisions dépassant 6 ou 8 bits.
- les convertisseurs "flash", qui utilisent 2^{N} comparateurs en parallèle ; les comparateurs reçoivent chacun d'une part le signal analogique et d'autre part l'une de 2^{N} tensions de références définies par un pont de 2^{N} résistances de précision ; ces convertisseurs sont très rapides (2 phases en général) mais ils sont très encombrants et consomment une puissance très importante lorsque N atteint 10 à 12 bits ;
- les convertisseurs mixtes ayant un convertisseur grossier pour l'obtention des bits de poids fort et un convertisseur fin pour l'obtention des bits de poids faible ; le convertisseur grossier peut être rapide et peu précis (4 à 6 bits par exemple); le convertisseur fin doit être précis même s'il est moins rapide.

Parmi les convertisseurs mixtes, on a déjà proposé plusieurs solutions.

Dans une solution, le convertisseur grossier est un convertisseur flash qui fournit P bits qui sont les bits de poids fort. Cette valeur est reconvertie en signal analogique par un convertisseur numérique-analogique de P bits ; la différence entre le signal analogique Vin et cette valeur reconvertie, appelée aussi reste ou résidu, est convertie par un convertisseur fin qui détermine les bits de poids faible de la conversion ; on gagne en consommation de puissance et encombrement par rapport à un convertisseur flash, mais la conversion numérique analogique prend du temps et nécessite un asservissement précis des gains des différentes parties de circuit (convertisseur analogique-numérique et numérique- analogique).

Dans une autre architecture de convertisseur mixte, on utilise ce qu'on appelle un convertisseur à repliement du signal analogique d'entrée ; le signal d'entrée Vin est appliqué à au moins deux circuits de repliement, dont la fonction est de fournir des signaux dits "repliés" Vr1, Vr1b, Vr2, Vr2b, ayant une amplitude qui varie avec l'amplitude du signal d'entrée Vin selon une fonction périodique (de forme à peu près sinusoïnale) ; la période est définie par l'écartement entre des valeurs de tension de référence régulièrement distribuées entre deux valeurs extrêmes ; les tensions de référence sont produites par un pont de résistances, et le nombre de tensions de référence utilisées par les blocs de repliement définit le nombre de périodes du signal replié dans la gamme maximale de variation possible du signal analogique d'entrée. Les fonctions Vr1 et Vr1b sont en opposition de phase, c'est-à-dire que le signal Vr1b est minimum pour la valeur de Vin pour laquelle Vr1 est maximum, et réciproquement. De même pour Vr2 et Vr2b. Les fonctions Vr1 et Vr2 sont en quadrature de phase, c'est-à-dire que le signal replié Vr2 est maximum ou minimum pour les valeurs d'entrée Vin pour lesquelles Vr1 est nulle, et réciproquement.

Les maxima et minima périodiques sont justement égaux aux tensions de référence utilisées par les circuits de repliement, les tensions de référence utilisées par le premier circuit de repliement étant alternées régulièrement avec celles utilisées par le deuxième. Les différences (Vr1-Vr1b), (Vr2-Vr2b) entre les signaux repliés issus des deux blocs, s'annulent périodiquement pour des valeurs de tension d'entrée qui sont justement les tensions de références; à partir de ces différences, on établit des signaux dits "interpolés", de même allure générale que les différences de signaux repliés, mais qui s'annulent pour des valeurs de tension d'entrée intermédiaires entre les valeurs de référence.

Ainsi, à partir d'un signal d'entrée Vin et d'une série de tensions de référence régulièrement distribuées, on établit au moins quatre signaux repliés Vr1, Vr1b, Vr2, Vr2b dont l'amplitude dépend de Vin (mais sous forme d'une fonction périodique) et plusieurs signaux interpolés périodiques, dont le signe positif ou négatif dépend de la différence entre Vin et des valeurs de tensions de référence intermédiaires entre les références initiales.

Les signaux interpolés permettent alors d'obtenir les poids faibles de la conversion numérique-analogique, représentant la position de Vin par rapport à ces valeurs de référence intermédiaires adjacentes. Les poids forts sont donnés par un convertisseur grossier qui indique dans quelle "période" des signaux repliés se situe la tension d'entrée analogique Vin, c'est-à-dire qui indique entre quelles valeurs adjacentes de tensions de référence se situe Vin. L'intérêt de cette architecture réside dans le fait que les circuits d'interpolation reçoivent des tensions (différences de signaux repliés) dont les amplitudes dépendent de la valeur exacte de la tension d'entrée Vin mais sont indépendantes de la gamme dans laquelle se situe Vin. Par conséquent, un seul circuit d'interpolation permet d'établir les poids faibles de la conversion, et ceci sans pour autant qu'il soit nécessaire d'utiliser un convertisseur numérique-analogique, donc sans ralentissement de l'opération de conversion et sans problèmes d'asservissement de gains.

Dans une architecture déjà proposée, le circuit d'interpolation comporte de simples ponts de résistances qui reçoivent par exemple les différences (Vr1-Vr2) et (Vr1b-Vr2b) entre les signaux repliés. Les prises intermédiaires de ces ponts de résistances fournissent les signaux interpolés ; elles sont appliquées deux à deux à des comparateurs qui basculent dans un sens ou dans l'autre selon la valeur des signaux interpolés donc selon la position de Vin entre deux tensions de références adjacentes. Voir EP-A-227 165 et EP-A-414 389.

Dans une autre architecture, le circuit d'interpolation comporte plusieurs étages en cascade ; le premier étage reçoit les quatre signaux repliés et les combine de manière à produire quatre autres signaux qui sont encore des fonctions périodiques de la tension analogique d'entrée Vin, mais avec cette fois une période double de la période des signaux repliés : ces nouveaux signaux passent par zéro non seulement lorsque Vin est égale aux tensions de référence ayant servi au repliement, mais aussi pour des tensions de référence intermédiaires situées au milieu de l'intervalle entre deux tensions de référence adjacentes. Les signaux permettent donc de fournir un bit d'information supplémentaire par rapport aux bits de poids forts obtenus par le convertisseur grossier. Les tensions ainsi obtenues en sortie du premier étage, sont appliquées à un deuxième étage qui a la même fonction (création de signaux de période à nouveau doublée) et qui fournit un bit supplémentaire pour la valeur de Vin. Ainsi de suite, plusieurs étages peuvent être mis en cascade pour obtenir les bits successifs de poids faible de la conversion. Il semble que le brevet US 5 126 742 décrit une architecture de ce type.

Que les circuits d'interpolation soient des circuits d'interpolation parallèle (application des signaux repliés à des ponts de résistance) ou des circuits d'interpolation en cascade, l'inconvénient majeur des architectures à repliement de signal analogique d'entrée est l'inconvénient inhérent aux circuits qui effectuent le repliement : on ne sait pas réaliser un signal replié qui soit véritablement symétrique par rapport à une valeur moyenne.

Or le fonctionnement des circuits d'interpolation qui sont placés en aval des circuits de repliement repose pour une grande part sur la symétrie très précise des quatre signaux de repliement. Une disymétrie même légère entre la valeur des maxima et la valeur des minima d'un signal replié entraîne un déplacement des valeurs de tension intermédiaires pour lesquelles les différences de signaux repliés s'annulent. Comme ces valeurs servent de référence pour la conversion des poids faibles, cela entraîne des erreurs de conversion qui peuvent être importantes.

Ces erreurs de symétrie peuvent partiellement être compensées par des circuits additionnels mais cela rend le circuit plus complexe, plus encombrant, moins sûr.

Par ailleurs, les convertisseurs analogiques-numériques à repliement de signal nécessitent un convertisseur grossier pour indiquer entre quelles valeurs de tension de référence se situe la tension d'entrée, et il est assez délicat de combiner les informations issues du convertisseur grossier avec les information issues de l'interpolation des signaux repliés, surtout pour tenir compte des cas où la tension à convertir est proche de la limite entre deux valeurs numériques consécutives fournies par le convertisseur grossier : il est parfois nécessaire de corriger les bits de poids fort en fonction des bits de poids faible.

Pour remédier aux inconvénients des convertisseurs analogiques-numériques connus et améliorer le compromis entre les performances de ces convertisseurs, surtout du point de vue de la précision, de la rapidité de fonctionnement, de la consommation, et du coût, l'invention propose une nouvelle architecture de convertisseur qui n'utilise pas de circuit de repliement du signal d'entrée analogique à convertir ; de ce fait, l'architecture proposée présente au moins l'avantage de ne pas souffrir des inconvénients inhérents à ces circuits de repliement.

Selon l'invention on propose un convertisseur analogique-numérique possédant une entrée pour recevoir une tension analogique Vin à convertir, comportant trois tensions de référence principales VR(i-1), VR(i), VR(i+1) [sauf exception, VR(i) est équidistante de VR(i-i) et VR(i+1], et trois amplificateurs différentiels recevant chacun sur une première entrée la tension à convertir Vin, susceptible de varier entre deux valeurs extrêmes Vext1 et Vext2 situées en dehors de l'intervalle entre les tensions de référence principales, les amplificateurs recevant sur une deuxième entrée respectivement chacun l'une des trois tensions de référence principales, chaque amplificateur fournissant deux tensions de sortie qui varient symétriquement en fonction de la tension Vin, sensiblement linéairement autour d'une valeur moyenne Vm qui est identique pour les trois amplificateurs et qui est obtenue en sortie d'un amplificateur lorsque les tensions sur les deux entrées de cet amplificateur sont égales, les tensions de sortie variant en outre de manière monotone en fonction de Vin pour des valeurs de Vin comprises entre les valeurs extrêmes Vext1 et Vext2, caractérisé en ce que le convertisseur comprend en outre un premier circuit d'interpolation recevant les six tensions de sortie des amplificateurs et fournissant quatre tensions d'interpolation de rang 1, variables en fonction de Vin selon une fonction qui, pour les valeurs de Vin comprises entre les tensions de référence principales, est sensiblement sinusoïdale, identique en amplitude pour les quatre tensions au déphasage près, et représentant une période unique de sinusoïde, les quatre tensions d'interpolation variant en sens inverse deux à deux, deux d'entre elles passant par une valeur moyenne et les deux autres présentant l'une un maximum, l'autre un minimum lorsque la tension Vin est égale à l'une quelconque des trois tensions de référence principales.

En résumé, on propose de créer six tensions analogiques à l'aide d'amplificateurs ordinaires (en ce sens qu'ils ne sont pas des amplificateurs à repliement de signal d'entrée), puis de créer à partir de ces six tensions quatre autres tensions analogiques dont les croisements définissent des tensions de référence intermédiaires qui sont utiles à la conversion analogique-numérique de la tension initiale Vin.

La structure qui vient d'être résumée permet en effet d'établir par différence des signaux dont les passages par zéro se produisent non seulement lorsque Vin est égale aux trois tensions de référence principales mais aussi lorsque Vin est égale à deux autres tensions de référence intermédiaires (qu'on peut appeler tensions intermédiaires de rang 1), situées à mi distance entre les tensions de référence principales prises deux à deux. Cela signifie qu'on peut comparer le signal Vin instantanément, et sans circuit de repliement du signal analogique d'entrée, à 5 valeurs de tensions de référence. On a donc un circuit de conversion analogique-numérique pouvant fournir un codage numérique sur au moins deux bits, avec en outre une possibilité de repérage de dépassement des limites VR(i-1) et VR(i+1).

De préférence, un comparateur de rang 0 reçoit les sorties de l'amplificateur différentiel relié à la tension de référence principale VR(i) et fournit un bit de poids le plus fort de la conversion de Vin. Un comparateur de rang 1 reçoit deux sorties du premier circuit d'interpolation (appelé aussi circuit d'interpolation de rang 1); plus précisément ce comparateur reçoit les deux tensions en opposition de phase qui passent par un maximum ou un minimum lorsque Vin est égal aux tensions de référence principales VR(i-1), VR(i), VR(i+1). Ce comparateur fournit un bit de rang 1 de la conversion de Vin.

Mais de plus, il est très important de remarquer qu'on obtient en sortie du circuit d'interpolation de rang 1 quatre tensions qui ont une allure générale sinusoïdale (une seule période) en fonction de Vin ; et les passages de ces signaux par une valeur moyenne (commune aux quatre signaux) sont à des valeurs de référence bien déterminées. Ces tensions d'interpolation de rang 1 peuvent donc elles-mêmes, si on le désire, être utilisées dans un circuit d'interpolation de rang 2 qui va permettre de produire quatre autres tensions d'interpolation de rang 2 (eux-mêmes utilisables dans un circuit de rang 3, etc.) repérées par rapport à quatre tensions de référence intermédiaires supplémentaires de rang 2, situées à mi-distance entre les tensions de références précédentes (principales et intermédiaires de rang 1). La comparaison entre les différentes tensions d'interpolation de rang 2 fournira alors un bit supplémentaire de la conversion analogique numérique du signal Vin.

Ainsi de suite, on peut prévoir plusieurs circuits d'interpolation dont le nombre définira le nombre de bits de conversion du signal analogique.

Par conséquent, on prévoit de préférence que le convertisseur analogique-numérique comporte au moins un circuit d'interpolation de rang k (k>1) recevant quatre tensions issues d'un circuit d'interpolation de rang k-1, et fournissant quatre tensions d'interpolation de rang k, variables en fonction de l'amplitude du signal Vin à convertir selon une fonction qui, pour les valeurs de Vin comprises entre les tensions de référence principales, est sensiblement sinusoïdale, identique en amplitude pour les quatre signaux au déphasage près, et représentant 2^{k-1} périodes de sinusoïde ; les quatre tensions d'interpolation de rang k variant en sens inverse deux à deux; deux d'entre elles passent par une valeur moyenne commune lorsque la tension Vin à convertir est égale à des valeurs dites "tensions intermédiaires de rang k", et passent l'une par un maximum l'autre par un minimum lorsque la tension Vin à convertir est égale aux valeurs de tension de référence principales et intermédiaires de rang 1 à k-1; les deux autres tensions d'interpolation de rang k passent par une valeur moyenne commune lorsque la tension Vin est égale à une tension de référence principale ou intermédiaire de rang 1 à k-1.

En créant ces quatre signaux d'interpolation de rang k, on définit 2^{k} tensions de référence intermédiaires supplémentaires de rang k, situées au milieu des intervalles entre les tensions de référence intermédiaires des différents rangs précédents (le rang 0 étant les tensions de référence principales).

Par conséquent, un avantage important de l'invention est de permettre une interpolation en série sur un nombre d'étages qui n'est limité dans la théorie que par la capacité des comparateurs à détecter avec précision l'égalité de deux signaux d'interpolation de rang déterminé.

On prévoit de préférence en sortie d'un circuit d'interpolation de rang k un comparateur de rang k recevant deux sorties de ce circuit, plus précisément les deux tensions en opposition de phase qui passent par un maximum ou un minimum lorsque Vin est égal aux tensions de référence intermédiaires de rang 0 à k-1. Ce comparateur fournit un bit de rang k de la conversion de Vin.

D'autre part, un autre avantage très important de l'invention est le fait que cette structure est compatible avec les architectures de convertisseur qu'on a appelées mixtes et qui utilisent à la fois une conversion grossière et une conversion fine. On peut en particulier réaliser des structures de convertisseurs mixtes qui simplifient beaucoup les problèmes de combinaison des bits de poids fort obtenus par le convertisseur grossier et des bits de poids faible obtenus par le convertisseur fin .

Le convertisseur selon l'invention pourrait bien sûr servir de convertisseur grossier, associé à une autre structure, identique ou différente, de convertisseur fin. Cependant, on pense qu'une structure très intéressante est celle dans laquelle le convertisseur selon l'invention est utilisé comme convertisseur fin associé à un circuit de sélection d'un groupe de trois tensions de référence principales parmi un nombre de tensions de référence principales supérieur à trois, ce circuit étant apte à comparer le signal d'entrée Vin aux différentes tensions de référence, à sélectionner un groupe de trois tensions de références principales adjacentes telles que Vin soit compris entre ces tensions de référence, et à établir les connexions nécessaires entre ces trois tensions de référence, trois amplificateurs différentiels, et au moins un circuit d'interpolation tel que défini précédemment selon l'invention.

On obtient donc une évaluation de la gamme de tensions dans laquelle se situe Vin, puis une conversion analogique numérique fine par interpolation en série à l'intérieur de la gamme de tensions sélectionnées.

Il peut y avoir trois amplificateurs seulement pour tout le circuit, auquel cas la circuiterie de sélection de gamme agit pour connecter trois tensions de référence sélectionnées à ces trois amplificateurs. Ou bien on peut avoir autant d'amplificateurs que de tensions de référence principales possibles (connectées chacune à un amplificateur respectif), auquel cas la circuiterie de sélection de gamme agit pour sélectionner les sorties de trois amplificateurs et les raccorder au circuit d'interpolation de rang 1.

La constitution d'un circuit d'interpolation est de préférence essentiellement la suivante : il comprend pour chaque groupe de deux signaux d'interpolation à produire, variant symétriquement en sens inverse, une cellule à trois paires de branches différentielles, chaque branche comportant au moins une charge et un transistor d'entrée dont l'électrode de commande (base d'un transistor bipolaire par exemple) constitue une entrée de signal pour cette branche. Les deux branches symétriques de la première paire sont alimentées par le courant de la première branche de la troisième paire et constituent ensemble la charge de cette première branche ; les deux branches de la deuxième paire sont alimentées par le courant de la deuxième branche de la troisième paire et constituent ensemble la charge de cette deuxième branche ; les premières branches des première et deuxième paire ont une charge commune, les deuxième branches des première et deuxième paires ont également une charge commune symétrique de l'autre.

Cette cellule est analogue à une structure de multiplieur connue dite "cellule de Gilbert".

Pour un circuit d'interpolation de rang k (k>1) il y a deux cellules d'interpolation; les signaux d'entrée appliqués à la première cellule sont en principe :
- deux premiers signaux d'interpolation de rang k-1 variant en opposition de phase en fonction de Vin, appliqués comme entrées à la première paire différentielle,
- ces mêmes signaux, croisés, appliqués à la deuxième paire différentielle,
- les deux autres signaux d'interpolation de rang k-1 appliqués à la troisième paire différentielle.

Les sorties sont prélevées sur les charges communes de la première et la deuxième paire différentielle et constituent deux signaux d'interpolation de rang k.

Pour la deuxième cellule d'interpolation du circuit d'interpolation de rang k, les signaux appliqués sont en principe les suivants :
- un premier et un deuxième signal d'interpolation de rang k-1 variant en quadrature de phase selon Vin, appliqués aux entrées de la première paire différentielle,
- les mêmes signaux mais croisés, appliqués aux entrées de la deuxième paire différentielle,
- un troisième signal d'interpolation de rang k-1, variant en opposition de phase avec le premier, est appliqué à une entrée de la troisième paire différentielle, le deuxième signal d'interpolation de rang k-1 étant appliqué à l'autre entrée de la troisième paire.

Les sorties de cette deuxième cellule, prélevées sur les charges communes de la première et la deuxième paire différentielle, constituent les deux autres signaux d'interpolation de rang k.

Pour le circuit d'interpolation de rang 1, il y a également deux cellules d'interpolation constituées de la même manière avec trois paires de branches différentielles chacune.

La première cellule reçoit :
- sur la première paire différentielle les signaux de sortie du premier amplificateur différentiel, variant en opposition de phase selon Vin, et s'annulant pour Vin égale à la première référence de tension principale VR(i-1) ;
- sur la deuxième paire différentielle, les signaux de sortie du troisième amplificateur, variant en opposition de phase et s'annulant pour Vin égale à la troisième référence de tension principale VR(i+1);
- sur la troisième paire différentielle, les signaux de sortie du second amplificateur, variant également en opposition de phase et s'annulant pour la deuxième référence de tension VR(i).

La deuxième cellule reçoit :
- sur la première paire différentielle une sortie du troisième amplificateur et une sortie du deuxième,
- sur la deuxième paire différentielle les mêmes signaux mais croisés,
- sur la troisième paire, d'une part une sortie du premier amplificateur et d'autre par une sortie du deuxième.

Les sorties de ce circuit d'interpolation de rang 1 sont prélevées sur les charges communes des première et deuxième paires différentielles de chacune des cellules.

D'autres caractéristiques et avantages de l'invention apparaîtront à la lecture de la description détaillée qui suit et qui est faite en référence aux dessins annexés dans lesquels :
- la figure 1 représente la constitution schématique de base d'un convertisseur analogique-numérique selon l'invention.
- les figures 2 à 5 représentent les courbes de variation de tensions en sortie des amplificateurs et circuits d'interpolation en fonction de la tension analogique Vin à convertir;
- la figure 6 représente un amplificateur différentiel;
- la figure 7 représente le circuit d'interpolation de rang 2;
- la figure 8 représente le circuit d'interpolation de rang 1;
- la figure 9 représente un convertisseur selon l'invention, avec sélection de sous-gammes de conversion.

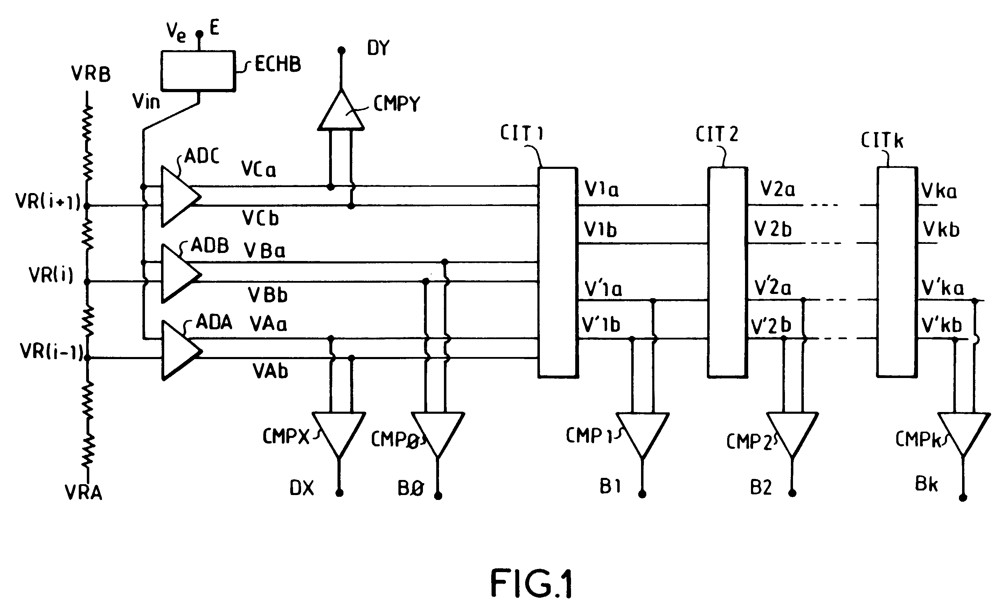

La structure générale du convertisseur selon l'invention est représentée à la figure 1. La fonction de ce convertisseur est de fournir un signal numérique de m bits représentant sous forme numérique la valeur de l'amplitude d'un signal analogique d'entrée Vin. Les m bits représentent selon un code binaire une valeur de Vin parmi 2^{m} valeurs distribuées régulièrement entre deux valeurs de référence principales VR(i-1) et VR(i+1).

Le signal d'entrée Vin peut prendre des valeurs quelconques entre deux valeurs extrêmes Vext1 et Vext2 qui peuvent aller bien au-delà de la gamme de valeurs situées entre VR(i-1) et VR(i+1), mais de toutes façons la sortie du convertisseur ne fournit une représentation numérique de Vin que si Vin est située entre VR(i-1) et VR(i+1). On verra toutefois que le convertisseur peut aussi fournir un signal de dépassement par le haut ou par le bas indiquant si Vin est en dehors de la gamme VR(i-1) à VR(i+1).

Les tensions de référence principales VR(i-1) et VR(i+1), ainsi qu'une autre tension de référence principale VR(i), équidistante des valeurs VR(i-1) et VR(i+1), sont appliquées chacune respectivement à une première entrée d'un amplificateur différentiel respectif ADA [pour VR(i-1)], ADB [VR(i)], ADC [VR(i+1)].

Les tensions de référence sont produites de manière quelconque, mais de préférence grâce à un pont de résistances de précision alimenté entre deux tensions de référence globales VRA et VRB ; les prises intermédiaires de ce pont sont calculées pour obtenir les tensions de référence principales VR(i-1), VR(i), VR(i+1).

Chaque amplificateur différentiel possède une deuxième entrée sur laquelle est appliquée la tension d'entrée Vin à convertir. De préférence, cette tension est issue de la sortie d'un échantillonneur-bloqueur ECHB ; la tension Vin de sortie reproduit périodiquement et maintient constante, entre deux instants d'échantillonnage successifs, la valeur que possède la tension Ve à l'entrée E de l'échantillonneur aux instants d'échantillonnage. Dans la suite on considérera que c'est la tension Vin qui constitue le signal d'entrée du convertisseur, bien que le signal analogique à convertir soit en réalité plutôt le signal Ve.

L'échantillonneur-bloqueur ECHB permet de maintenir constante la valeur du signal à convertir pendant une durée suffisante pour que la conversion analogique-numérique soit complètement terminée.

Les amplificateurs différentiels ADA, ADB, ADC, sont identiques. Les particularités de leur fonction de transfert (fonction représentant l'évolution de leurs tensions de sortie en fonction de leur tension d'entrée) seront précisées ci-après. Mais d'ores et déjà on peut dire que ces particularités sont obtenues avec des amplificateurs de type très courant constitués dans leur version la plus simple par exemple par une paire de branches différentielles alimentées globalement par une source de courant constant, avec un transistor d'entrée et une charge résistive dans chaque branche. Il ne s'agit donc en aucun cas de circuits de repliement du signal d'entrée Vin à convertir.

Chaque amplificateur possède deux sorties différentielles. Il fournit sur ces sorties deux tensions qui varient symétriquement en fonction de la valeur de Vin, sensiblement linéairement autour d'une valeur moyenne Vm, commune pour les deux sorties et identique pour les trois amplificateurs ; cette valeur moyenne commune est celle qui est obtenue en sortie d'un amplificateur lorsque les tensions sur les deux entrées de cet amplificateur sont égales. De plus, les amplificateurs sont tels que les tensions de sortie sur les sorties différentielles varient de manière monotone avec Vin pour toute la gamme de valeurs possibles de Vin (dans l'intervalle VR(i-1) à VR(i+1) et, au-delà, dans l'intervalle Vext1 à Vext2 des valeurs possibles pour Vin).

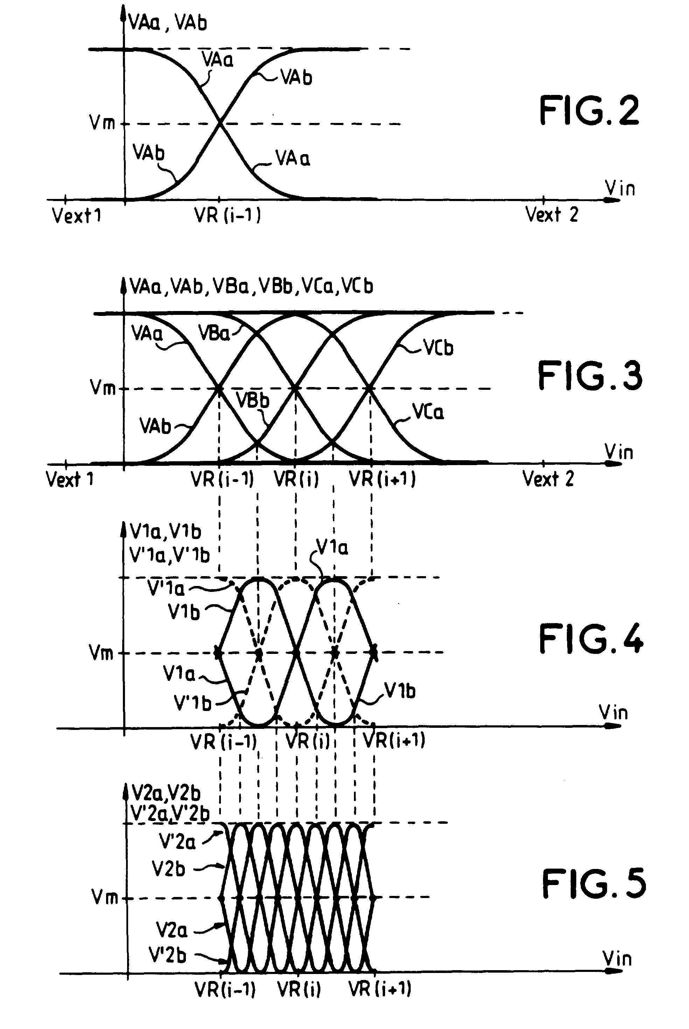

La figure 2 représente les valeurs des deux tensions différentielles de sortie (VAa, VAb) pour un amplificateur unique (ADA) ; la figure 3 représente en superposition les six tensions de sortie correspondant aux trois amplificateurs : (VAa, VAb) pour ADA, (VBa, VBb) pour ADB, (VCa, VCb) pour ADC. Les courbes ne représentent pas des formes d'onde temporelles des tensions de sortie mais les évolutions de ces tensions (VAa, VAb, VBa, VBd, VCa, VCb) en fonction de la valeur de tension d'entrée Vin.

Les courbes VAa et VAb de la figure 2 représentent les fonctions de transfert classiques d'un amplificateur différentiel symétrique simple à deux transistors d'entrée, ayant une entrée portée à la tension de référence VR(i-1) et l'autre à Vin. Les courbes VAa et VAb sont symétriques, monotones, et elles se coupent en un point d'abscisse VR(i-1) et d'ordonnée Vm, où Vm est la valeur de potentiel commune des sorties pour une tension d'entrée différentielle nulle c'est-à-dire lorsque la tension d'entrée Vin appliquée à une entrée est égale à la référence, ici VR(i-1), appliquée à l'autre entrée.

Les portions de courbes aux alentours du point où elles se rencontrent sont sensiblement linéaires, puis, plus on s'éloigne de ce point, plus on tend asymptotiquement vers deux valeurs extrêmes de potentiel qui dépendent des tensions et courants de polarisation de l'amplificateur. Les pentes des portions sensiblement linéaires sont plus faibles si une résistance d'émetteur est placée en série avec l'émetteur du transistor dans chaque branche différentielle de l'amplificateur. La linéarité de la portion sensiblement linéaire est en outre améliorée avec une telle résistance d'émetteur et il pourra donc être avantageux de prévoir des amplificateurs différentiels avec résistances d'émetteur. Cependant, une linéarité parfaite n'est pas nécessaire ; le paramètre de qualité important est plutôt dans l'égalité de la valeur moyenne Vm pour les trois amplificateurs et dans le parallélisme des courbes pour les trois amplificateurs.

Sur la figure 3, on a représenté les courbes pour les trois amplificateurs. Ces courbes sont identiques mais décalées latéralement les unes par rapport aux autres puisque elles sont centrées sur trois tensions de référence différentes VR(i-1), VR(i) et VR (i+1).

Ces courbes permettent déjà de montrer qu'on peut obtenir en sortie du deuxième amplificateur une information sur le fait que Vin est supérieur ou non à VR(i). En effet, la différence des signaux VBa et VBb est positive si Vin est inférieur à VR(i) et négative si Vin est supérieur à VR(i). Un simple comparateur CMP0 (comparateur de rang 0), ayant deux entrées recevant les deux sorties du deuxième amplificateur, fournit à sa sortie un bit B0 (bit de rang 0) d'information numérique indiquant si Vin se situe au-dessus ou au-dessous de VR(i).

De même, si on le désire, on peut prévoir un comparateur CMPX recevant les sorties du premier amplificateur ADA pour fournir un signal logique DX de dépassement vers le bas [Vin <VR(i-1)], et également un comparateur CMPY recevant les sorties du troisième amplificateur pour fournir un signal logique DY de dépassement vers le haut [Vin>VR(i+1)].

On remarque sur les courbes de la figure 3 que les courbes VAa et VBb se croisent exactement au milieu de l'intervalle entre VR(i-1) et VR(i). Il en est de même des courbes VBa et VAb. De la même manière, le croisement des courbes VBb et VCa, où des courbes VBa et VCb, est situé exactement au milieu de l'intervalle VR(i), VR(i+1). On peut donc, en utilisant les sorties correspondantes des amplificateurs, déterminer si Vin est au-dessus ou au-dessous des tensions de référence intermédiaires définies par ces croisements de courbes.

Par exemple un comparateur recevant les sorties VAa et VBb fournit un signal logique indiquant si Vin est supérieur ou inférieur à la tension intermédiaire de croisement entre VAa et VBb. En effet, le signe de VAa-VBb, détecté par ce comparateur, est positif si Vin est supérieur à la tension intermédiaire, négatif dans le cas contraire. On peut ainsi obtenir la valeur de Vin avec un codage sur 2 bits, par comparaison avec cinq tensions de référence qui sont les tensions de référence principales VR(i-1), VR(-i), VR(i+1) et deux tensions de référence intermédiaires qui sont les milieux des intervalles entre les tensions de référence principales.

Cependant, on préfère utiliser une solution plus complexe mais permettant d'obtenir un codage numérique sur plus de deux bits.

Pour cela, les six signaux de sortie analogiques des amplificateur ADA, ADB, ADC sont appliqués aux entrées d'un premier circuit CIT1 qu'on peut appeler de manière imagée "premier circuit d'interpolation" parce qu'il a pour fonction l'établissement de signaux qui permettront de définir les valeurs de tensions de référence fictives intermédiaires mentionnées précédemment. Ces tensions de référence intermédiaires sont obtenues en quelque sorte par interpolation entre les tensions de référence principales. On les appellera tensions de référence intermédiaires de rang 1, et on verra qu'on peut créer ensuite d'autres tensions de référence intermédiaires de rangs successifs 2, 3, etc... situées à chaque fois au milieu de l'intervalle entre deux tensions de référence adjacentes faisant partie des rangs précédents (le rang 0 étant celui des tensions de référence principales).

Le premier circuit d'interpolation CIT1 produit donc des signaux analogiques qui permettent d'établir fictivement les tensions de référence intermédiaires de rang 1, mais sa fonction est également de faire en sorte que ces signaux analogiques puissent eux-mêmes être transmis à un circuit d'interpolation de rang suivant qui jouera un rôle semblable.

De même que les courbes VAa, VAb en fonction de Vin se croisent lorsque Vin est égal à une tension de référence principale et de même que les courbes VAa et VBb se croisent lorsque Vin est égal à la tension intermédiaire de rang 1, on va produire à l'aide du circuit CIT1.
- d'une part deux signaux symétriques V1a et V1b qui se croisent chaque fois que Vin est égal aux tensions de référence principales ;
- d'autre part deux signaux symétriques V'1a et V'1b qui se croisent chaque fois que Vin est égal aux tensions de référence intermédiaires ; les courbes V'1a et V'b sont identiques en amplitude et en forme aux courbes V1a et V1b mais décalées puisque les points de croisement ne sont pas aux mêmes endroits.

Il en résultera alors que la courbe V1a croise les courbes V'1a et V'1b pour de nouvelles tensions de référence intermédiaires situées au milieu des intervalles définis par les tensions de référence précédentes (principales ou intermédiaires de rang 1). Ces nouvelles références fictives seront appelées tensions intermédiaires de rang 2.

Pour produire des signaux analogiques qui se croisent périodiquement à l'endroit des trois références de tension principales, on utilise une structure différentielle double, du type des cellules de Gilbert utilisées en d'autres circonstances comme multiplicateurs de fréquence. Ces structures sont constituées essentiellement par deux paires de branches différentielles alimentées non pas par un courant fixe comme dans un amplificateur simple mais alimentées chacune par une branche respective d'une troisième paire différentielle. Chaque branche différentielle comporte une entrée différentielle et reçoit sur cette entrée deux signaux d'entrée pris parmi les signaux dont les fonctions de transfert se croisent. Les sorties des deux premières paires différentielles sont reliées entre elles et constituent les sorties de la structure.

Ces signaux de sortie sont égaux chaque fois que l'une quelconque des trois entrées différentielles passe à zéro. Ainsi, si on applique ;
- aux entrées différentielles de la première paire les signaux VAa et VAb qui se croisent pour Vin égal à VR(i-1),
- aux entrées de la deuxième paire les signaux VCa et VCb qui se croisent pour Vin = VR(i+1),
- et aux entrées de la troisième paire des signaux VBa et VBb qui se croisent pour Vin = VR(i),
alors on obtient deux signaux de sortie V1a et V1b qui sont égaux chaque fois que Vin passe par une des trois tensions de référence principales.

La forme de la courbe de variation des signaux V1a et V1b est alors la forme générale approximative d'une période unique de sinusoïde partant de Vin = VR(i-1), se terminant pour Vin = VR(i+1), et passant par un maximum ou un minimum pour les valeurs de tension intermédiaires de rang 1 situées au milieu de l'intervalle entre les tensions de référence principale . Les tensions V1a et V1b sont symétriques, c'est-à-dire que l'une croit quand l'autre décroît et réciproquement.

C'est ce que représente la figure 4 où les courbes sensiblement sinusoïdales V1a et V1b sont représentées en traits pleins. La forme de ces courbes n'est pas mathématiquement sinusoïdale mais ceci n'a pas d'importance pourvu que la symétrie des courbes soit respectée et pourvu que les courbes soient identiques (au décalage près) en amplitude et en forme aux courbes V'1a et V'1b qu'on va également produire par le circuit CIT1.

Pour produire les signaux V'1a et V'1b, le circuit CIT1 comporte une autre cellule du même type que celle qui a été décrite ci-dessus, c'est-à-dire une cellule à trois paires de branches différentielles, mais au lieu que les signaux d'entrée différentiels soient ceux qui se croisent pour les tensions de référence principale, on choisit comme entrées différentielles des couples de signaux qui se croisent pour les tensions intermédiaires de rang 1.

Ainsi, les signaux VAb et VBa se coupent pour la première tension intermédiaire de rang 1 ; ils seront appliqués à l'entrée d'une paire différentielle ; de même les signaux VBa et VCb sont égaux pour la deuxième tension intermédiaire de rang 1 ; ils seront appliquées à l'entrée d'une autre paire différentielle ; la dernière des trois paires différentielles pourra recevoir les mêmes signaux VBa et VCb, ou VAb et VBa, ou d'autres couples de signaux se coupant aux tensions de référence intermédiaires.

La figure 4 montre en traits pointillés les signaux V'1a et V'1b, qui ont la même forme et amplitude que V1a et V1b, mais dont les croisements sont situés au milieu des intervalles entre les tensions de référence principales. Ces signaux représentent aussi, entre les références de tension principales, chacune une période unique de courbe à peu près sinusoïdale, ces courbes étant symétriques et présentant des maxima et minima aux valeurs de tensions de référence principales.

On peut déjà remarquer que les courbes V1a et V1b croisent les courbes V'1a et V'1b pour des valeurs de tension Vin situées au milieu des intervalles entre les tensions de référence précédemment définies. Ces nouvelles valeurs de référence, fictives puisqu'elles ne sont pas matérialisées dans le circuit, seront les valeurs de référence intermédiaires de rang 2.

En dehors de l'intervalle VR(i-1), VR(i+1), la forme des courbes V1a, V1b, V'1a, V'1b n'a pas d'importance.

La valeur moyenne des signaux V1a, V1b, V'1a, V'1b est la même pour les quatre signaux mais n'a pas besoin d'être la même valeur Vm que pour les signaux VAa, VAb, etc... On a cependant indiqué Vm sur la figure 4 par souci de simplification des notations.

En sortie du premier circuit d'interpolation CIT1, on peut connecter un comparateur CMP1 (comparateur de rang 1) recevant les signaux V'1a et V'1b et indiquant où se situe Vin par rapport aux tensions intermédiaires de rang 1; en effet, le signe de V'1a-V'1b change à chaque fois que Vin passe par une tension intermédiaire de rang 1, sans changer pour d'autres valeurs de Vin. Le comparateur CMP1 fournit donc un bit supplémentaire d'information B1 (bit de rang 1). On verra plus loin que le code binaire obtenu par les bits B0,B1, etc... et représentant la valeur numérique du signal analogique Vin est un code de Gray et non un code binaire pur classique.

Pour continuer le codage numérique du signal analogique, on va répéter successivement l'opération de transformation de la paire de signaux symétriques ayant pour points de croisement les tensions intermédiaires de rang 1 et de la paire de signaux symétriques ayant pour points de croisement les tensions de référence principales de rang 0, en deux paires de signaux symétriques dont l'une a pour points de croisement les tensions intermédiaires des rangs précédents (0 ou 1) et l'autre a pour point de croisement des tensions intermédiaires de rang 2 qui sont les points de croisement mutuels d'un signal d'une paire de signaux d'entrée avec les deux signaux de l'autre paire.

Plus généralement on pourra mettre en cascade plusieurs circuits d'interpolation CIT2, CIT3... etc... de rang 2, 3, etc..., le circuit d'interpolation de rang k recevant comme signaux d'entrée une première paire de signaux symétriques V(k-1)a et V(k-1)b qui se croisent pour des tensions de référence de rangs 0 à k-2 et une deuxième paire de signaux symétriques V'((k-1)a et V'(k-1)b qui sont en quadrature de phase avec la première paire et qui se croisent pour des tensions de référence de rang k-1, ces deux paires étant les signaux de sortie du circuit d'interpolation de rang précédent k-1 ; à partir de ces signaux, le circuit d'interpolation de rang k produit une première paire de signaux de sortie symétriques ayant pour points de croisement toutes les tensions de référence de rangs 0 à k-1 et l'autre ayant pour points de croisement des tensions de référence de rang k qui sont situées au milieu des intervalles entre les références de rangs précédents et qui sont les points de croisement de valeurs d'un signal d'une des paire de signaux d'entrée avec les deux signaux de l'autre paire.

C'est ce qu'illustre la figure 5 avec les courbes représentant en fonction de Vin les valeurs de signaux de sortie du deuxième circuit d'interpolation CIT2.

La première paire de signaux de sortie symétriques V2a, V2b, se croise aux valeurs de tensions de référence principales et intermédiaires de rang 1; la deuxième paire V'2a, V'2b a respectivement ses maxima et ses minima en ces mêmes points. Et le croisement mutuel de la paire V2a, V2b avec la paire V'2a, V'2b définit les tensions de référence intermédiaires de rang 2.

Comme on peut le voir sur la figure 5, les signaux issus du circuit de rang 2 ont une forme approximativement sinusoïdale entre les valeurs de référence VR(i-1) et VR(i+1) et couvrant chacun exactement deux périodes. Les signaux issus du circuit de rang k couvrent 2^{k-1} périodes. En dehors de la gamme VR(i-1) à VR(i+1) la forme des courbes n'a pas d'importance.

A la sortie du circuit CIT2 on place un comparateur de rang 2 CMP2 recevant les signaux V'2a et V'2b qui se croisent pour les tensions de référence intermédiaires de rang 2, et ce comparateur fournit un bit B2 de rang 2 précisant la position de la tension Vin par rapport à ces tensions. De même, un comparateur CMPk de rang k recevant des signaux V'ka et V'kb issus du circuit d'interpolation de rang k, fournit un bit Bk de rang k précisant la position de Vin par rapport aux tensions intermédiaires de rang k.

On a ainsi décrit la structure générale du convertisseur selon l'invention. La sortie numérique est constituée par les bits B0.. Bk. Ces bits sont codés selon un code de Gray, c'est-à-dire un code dans lequel les valeurs croissantes (ou décroissantes) de Vin correspondent à des codes binaires successifs tels qu'un seul bit change d'état à chaque fois que Vin augmente ou diminue d'une quantité suffisante pour engendrer une nouvelle valeur numérique.

Par exemple, pour un codage de Gray sur 3 bits, les valeurs numériques successives de Vin peuvent correspondre aux codes suivants : 000, 001, 011, 010 110, 111, 101, 100.

Si on souhaite une sortie codée en binaire pur, on placera en sortie des comparateur CMP0 .... CMPk .... un transcodeur code Gray/code binaire pur.

On va préciser un exemple de constitution pratique pour les circuits de l'invention, surtout les circuits d'interpolation.

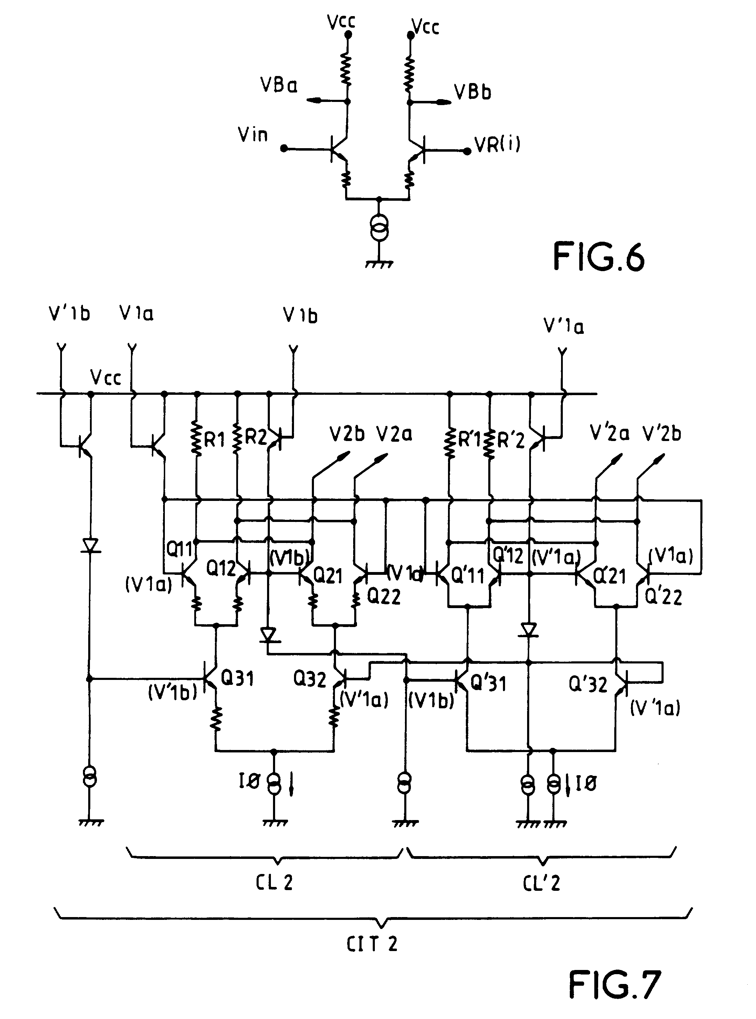

Tout d'abord, la figure 6 représente un schéma de réalisation pratique de l'amplificateur ADB (même schéma pour ADA et ADC). Ce schéma montre que ces amplificateurs sont des amplificateurs différentiels classique, avec deux branches différentielles alimentées ensemble par une source de courant constant, et, dans chaque branche différentielle, un transistor d'entrée (avec ou sans résistance d'émetteur) et une charge résistive. Les entrées sont les bases des transistors, les sorties sont les collecteurs.

La figure CONVERTISSEUR ANALOGIQUE NUMERIQUE 7 représente le circuit d'interpolation CIT2 de rang 2 ou n'importe quel circuit de rang k supérieur à 2.

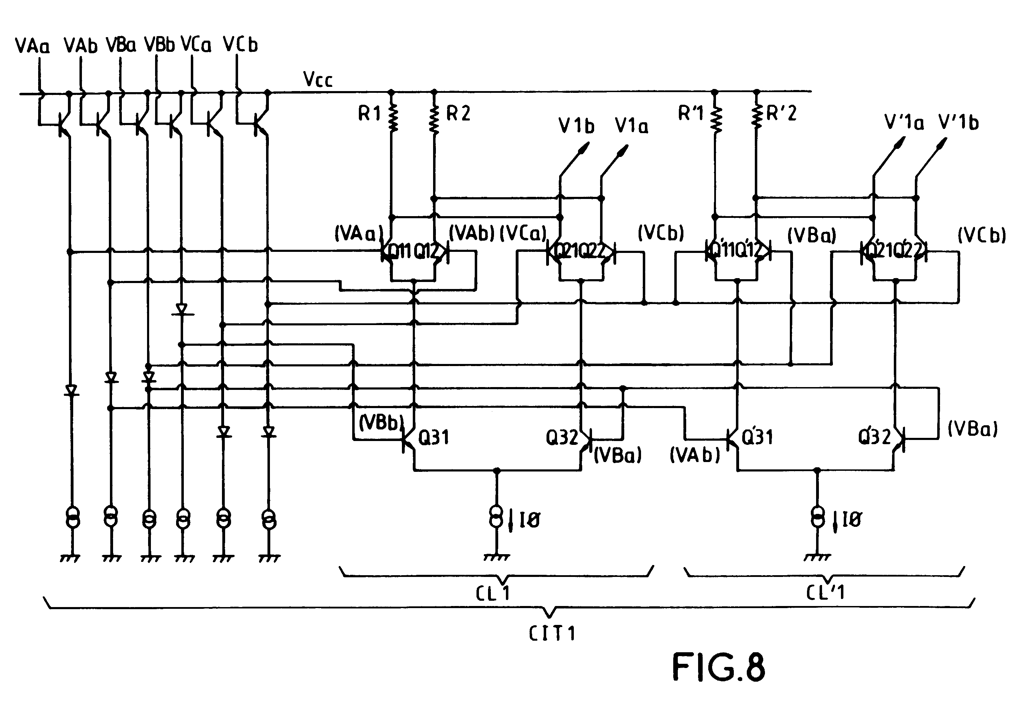

La figure 8 représente le circuit d'interpolation de rang 1 qui est légèrement différent des autres puisqu'il possède six entrées et non quatre comme les autres.

Sur la figure 7, on peut voir que le circuit CIT2 comprend essentiellement deux cellules à trois paires de branches différentielles chacune. La première cellule CL2 sert à produire les tensions V2a et V2b ; la deuxième cellule CL'2 sert à produire les tensions V'2a et V'2b. Chaque branche différentielle comporte classiquement au moins un transistor d'entrée et une charge. Pour les deux premières paires, les charges sont communes : la première branche de la première paire est reliée à la même charge (R1) que la première branche de la deuxième paire ; de même pour les deuxièmes branches de ces deux paires, reliées à la même charge R2.

Les charges de la troisième paire de branches différentielles sont constituées respectivement par la première paire et la deuxième paire de branches. Autrement dit, la première paire différentielle est alimentée par le courant de la première branche de la troisième paire; et la deuxième paire est alimentée par le courant de l'autre branche de la troisième paire.

Les transistors d'entrée Q11, Q12 de la première paire reçoivent sur leur base respectivement les tensions V1a et V1b. Ces tensions sont appliquées par l'intermédiaire de transistors montés en suiveurs de tension, pour des questions d'adaptation d'impédance. La chute de tension introduite par ces suiveurs est neutralisée par la symétrie du montage. Les transistors d'entrée Q21, Q22 de la deuxième paire reçoivent sur leur base les mêmes tensions mais croisées : V1b et V1a. Les transistors d'entrée Q31 et Q32 de la troisième paire reçoivent respectivement les signaux V'1b et V'1a. Des diodes de décalage de niveau permettent d'une manière classique de faire en sorte que les références de potentiel sur la troisième branche soient les mêmes que sur les deux autres.

La troisième paire différentielle est alimentée par une source de courant constant.

Les tensions prélevées sur les collecteurs des transistors Q12 et Q11 constituent les deux premiers signaux de sortie V2a et V2b du circuit CIT2.

On remarquera que les transistors d'entrée des différentes branches de la cellule CL2 comportent des petites résistances d'émetteur (quelques dizaines d'ohms). Elles modifient le gain de l'étage et sont calculées pour obtenir des signaux V2a et V2b ayant les variations d'amplitude désirées en fonction de Vin. Ces variations d'amplitude doivent être les mêmes que celles des signaux V'2a et V'2b.

La deuxième cellule CL'2 est semblable à la cellule CL2 sauf qu'elle peut ne pas comporter de résistances d'émetteur ; d'autre part elle reçoit des signaux d'entrée différents. Les éléments qui la composent sont désignés par des références semblables à celles de la cellule CL2, avec le symbole "prime". La première paire différentielle reçoit sur ses transistors d'entrée Q'11 et Q'12 des tensions V1a et V1b. La deuxième paire reçoit sur ses transistors d'entrée Q'21 et Q'22 les mêmes signaux mais croisés : V1b et V1a. La troisième paire reçoit V1b sur le transistor Q'31 de la première branche et V2a sur le transistor Q'32 de la deuxième branche. Le courant d'alimentation de la troisième branche est le même que pour la cellule CL2.

Sur la figure 8, on a représenté le premier circuit d'interpolation CIT1. Sa constitution est très semblable à celle du circuit CIT2, avec deux cellules CL1 et CL'1 pour produire respectivement la paire de signaux différentiels V1a, V1b, et la paire V'1a, V'1b dont la variation en fonction de Vin est en quadrature de phase avec la paire V1a, V1b.

Les cellules CL1 et CL'1 sont construites de la même manière que la cellule CL'2 de la figure 7. Seuls les signaux d'entrée appliqués aux bases des transistors des branches différentielles sont différents.

Pour la cellule CL1, les signaux d'entrée sont par exemple :
- VAa et VAb pour la première paire de branches différentielles,
- VCa et VCb pour la deuxième,
- VBb et VBa pour la troisième.

Pour la cellule CL'1, les signaux d'entrée sont par exemple :
- VCb et VBa pour la première paire,
- VBa et VCb pour la deuxième,
- VAb et VBa pour la troisième.

Sur la figure 8, étant donné la grande similarité des cellules CL1 et CL'1 avec les cellules CL2 et CL'2, les mêmes références numériques ont été utilisées pour désigner les éléments correspondants.

On va montrer maintenant comment on peut utiliser le circuit de la figure 1 d'une manière particulièrement avantageuse comme circuit de conversion fine pour l'obtention des bits de poids faible, dans un convertisseur comprenant également des moyens de conversion grossière pour l'obtention des bits de poids fort.

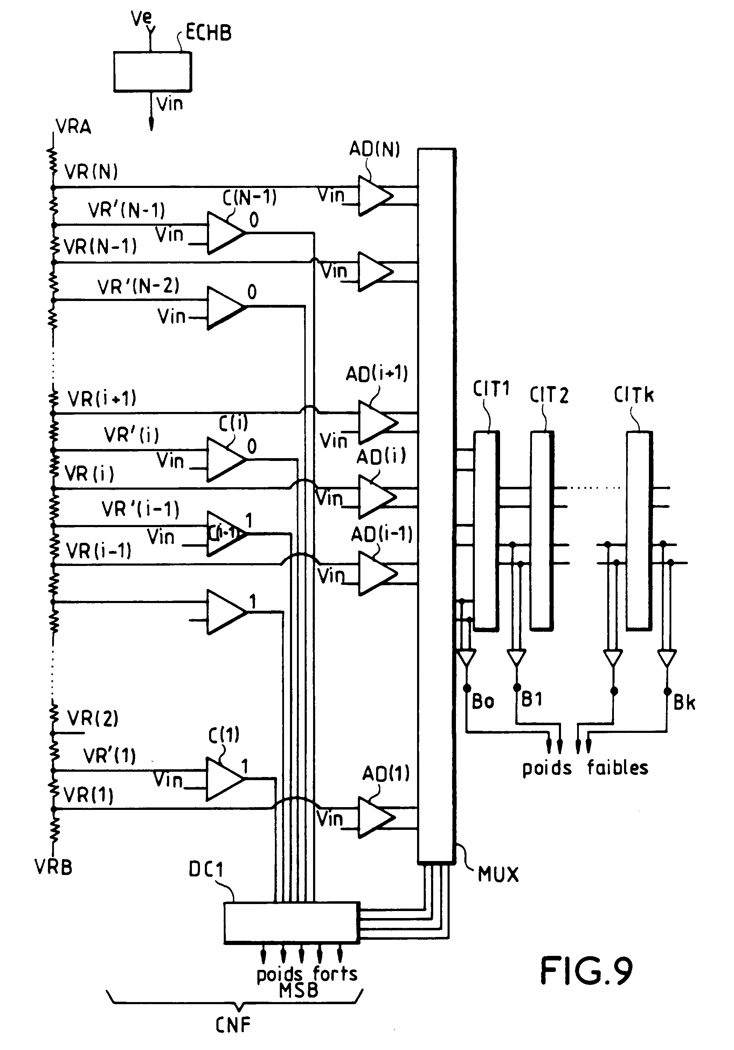

La figure 9 représente un exemple d'architecture globale d'un tel convertisseur.

Le convertisseur comporte un pont de résistances de précision alimenté entre deux tensions de référence extrêmes VRA et VRB. Les prises intermédiaires de ce pont définissent d'une part N premières références de tension équidistantes VR(1) VR(2)... VR(i)... VR(N), et d'autre part N-1 secondes références VR'(1), VR'(2),...VR'(i)...VR'(N-1) intermédiaires entre les N premières et de préférence situées au milieu des intervalles successifs entre les premières références. N est égal à 32 si on veut 5 bits de poids fort.

Les N secondes références VR'(1) à VR'(N) sont les références de tension d'un convertisseur analogique-numérique flash CNF qui reçoit par ailleurs le signal d'entrée analogique Vin à convertir. Le convertisseur flash est constitué à l'aide de N-1 comparateurs C(1) à C(N-1) et un décodeur DC1. Les comparateurs fournissent N sorties logiques selon un code dit "thermométrique", c'est-à-dire que si Vin est compris par exemple entre VR'(i-1) et VR'(i), alors les i-1 premiers comparateurs de la série fournissent une sortie logique à un premier niveau (1 par exemple) et tous les suivants fournissent l'état complémentaire (0). Le décodeur DC1 placé en sortie des comparateurs C(1) à C(N-1) permet de convertir ce code en un code binaire représentant les poids forts de la valeur numérique du signal analogique Vin.

Les N premières références de tension VR(1) à VR(N) sont appliquées chacune à la première entrée d'un amplificateur différentiel respectif AD(1) à AD(N) qui reçoit sur une autre entrée la tension analogique Vin. Les amplificateurs sont du type de ceux qui ont été décrits en référence à la figure 1, c'est-à-dire des amplificateurs qui fournissent deux tensions symétriques variant de manière monotone sur toute la gamme de variation possible de la tension Vin, ces tensions prenant une valeur commune moyenne Vm lorsque la différence entre leurs tensions d'entrée s'annule. Les amplificateurs différentiels peuvent donc être des amplificateurs différentiels analogiques classiques tels que celui de la figure 6.

Le signal d'entrée Vin appliqué à l'entrée des comparateurs et des amplificateurs différentiels est de préférence le signal issu d'un échantillonneur bloqueur ECHB tel que celui de la figure 1.

Les signaux logiques issus du convertisseur flash, en sortie des comparateurs C(1) à C(N-1), ou en sortie du décodeur DC1, servent non seulement à fournir les bits de poids fort de la conversion, mais servent aussi à sélectionner trois amplificateurs différentiels adjacents AD(i-1), AD(i), AD(i+1), dont les références de tension VR(i-1), VR(i), VR(i+1) sont les plus proches de la valeur de codage grossière obtenue pour Vin.

Si Vin est compris entre VR'(i-1) et VR'(i) (qui sont respectivement situées à mi-distance de VR(i-1) et VR(i) d'une part, VR(i) et VR(i+1) d'autre part), alors les trois amplificateurs AD(i-1), AD(i), AD(i+1), qui reçoivent comme références d'entrée VR(i-1), VR(i), VR(i+1), sont sélectionnés. Les sorties de ces trois amplificateurs sont alors connectées, par un multiplexeur analogique MUX, à un premier circuit d'interpolation CIT1 qui est celui des figures 1 et 8. Le multiplexeur est commandé par les sorties du décodeur DC1 ou par les sorties des comparateurs C(1) à C(N-1). Les sorties des autres amplificateurs ne sont pas utilisées.

Les sorties du circuit CIT1 sont connectées à un circuit d'interpolation suivant CIT2, qui lui-même est relié à un troisième, etc. On a donc une cascade de k circuits d'interpolation CIT2,...CITk (k = 5 par exemple pour obtenir 7 bits de poids faible), selon le même schéma qu'à la figure 1. Des comparateurs tels que les comparateurs CMP0 à CMPk de la figure 1, placés en entrée ou sortie des circuits d'interpolation CIT1 à CITk fournissent les bits de poids faible B0 à Bk de la conversion .

Par conséquent, le convertisseur flash CNF constitué à l'aide des comparateurs C(1) à C(N-1) fournit une valeur numérique représentant la position de Vin par rapport aux références de tension VR'(1) à VR'(N-1), et ce convertisseur indique donc un triplet de valeurs de référence VR(i-1), VR(i), VR(i+1) entre lesquelles se situe Vin. Le convertisseur à interpolations successives CIT1, CIT2... CITk fournit sous forme numérique la position plus précise de Vin à l'intérieur de ce triplet.

Les bits de poids faible et les bits de poids fort sont ajoutés dans un additionneur non représenté pour aboutir à une valeur numérique globale de Vin.

On remarquera que le même pont de résistances sert à la conversion grossière (poids forts) de Vin et à la conversion fine (poids faible) du résidu.

Par ailleurs, on remarquera qu'on a choisi pour les comparateurs C(1) à C(N-1) des références de tension VR'(1) à VR'(N-1) différentes des références VR(1) à VR(N) des amplificateurs. Ceci n'est pas obligatoire mais cela permet d'avoir un recouvrement entre la conversion de poids fort et la conversion de poids faible, afin d'éviter des erreurs de conversion lorsque Vin est voisin des valeurs de référence. De préférence, les tensions VR'(i) sont intercalées exactement au milieu des intervalles entre tensions VR(i).

Plus précisément, on peut dire que l'écart de tension entre VR(i-1) et VR(i) représente le bit de poids le plus fort de la conversion fine, c'est-à-dire le bit B0 de poids le plus fort parmi les bits de poids faibles. L'écart de tension entre VR'(i-1) et VR'(i) représente un bit de poids faible de la conversion grossière qui doit être identique au bit B0. L'écart entre VR(i-1)et VR'(i-1) représente la moitié d'un bit de poids faible de la conversion grossière et constitue le recouvrement de mesure vers le bas ; de même l'écart entre VR'(i) et VR(i+1) représente la moitié d'un bit de poids faible de la conversion grossière et constitue le recouvrement vers le haut.

Dans ces conditions, si Vin est compris entre VR'(i-1) et VR'(i) mais très proche de VR'(i-1) par exemple, entraînant le risque que les amplificateurs AD(i-2), AD(i-1) et AD(i) soient sélectionnés au lieu de AD(i-1), AD(i) et AD(i+1), alors Vin est loin de VR(i-1) et de VR(i) et la conversion fine fournira de toutes façon une valeur qui tiendra compte sans ambiguïté de la sélection d'amplificateurs qui aura été faite. Une simple addition des bits de poids faible et des bits de poids fort (avec leurs poids respectifs) permet donc, grâce à l'utilisation d'un pont de résistances commun et d'un recouvrement entre les valeurs de tensions de référence, d'obtenir une valeur non erronée de Vin quelle que soit sa position par rapport aux tensions de référence. Ceci n'est pas possible dans de nombreuses architectures de convertisseurs mixtes.

Dans l'architecture représentée à la figure 9, on a prévu N amplificateurs AD(1) à AD(N) dont les sorties sont reliées aux 2N entrées d'un multiplexeur qui peut transmettre 3 paires de signaux au circuit CIT1. Mais on pourrait aussi prévoir que le multiplexeur ait N entrées et 3 sorties et soit placé immédiatement en sortie du pont de résistances, pour sélectionner 3 tensions de références VR(i-1), VR(i), VR(i+1) et les transmettre à l'entrée de 3 amplificateurs ADC, ADB, ADA tels que ceux de la figure 1. Dans ce cas il n'y a pas N amplificateurs parmi lesquels on en choisit trois, mais seulement trois amplificateurs recevant trois tensions de référence sélectionnées parmi N. Cela suppose cependant que le multiplexeur soit capable de transmettre à sa sortie, sans les altérer, les tensions de référence sélectionnées.

## Revendications

1. Convertisseur analogique-numérique possédant une entrée pour recevoir une tension analogique Vin à convertir, comportant trois tensions de référence principales VR(i-1), VR(i), VR(i+1), et trois amplificateurs différentiels (ADA, ADB, ADC) recevant chacun sur une première entrée la tension à convertir Vin, susceptible de varier entre deux valeurs extrêmes Vext1 et Vext2 situées en dehors de l'intervalle entre les tensions de référence principales, les amplificateurs recevant sur une deuxième entrée respectivement chacun l'une des trois tensions de référence principales, chaque amplificateur fournissant deux tensions de sortie (VAa, VAb ; VBa ; VBb ; VCa, VCb) qui varient symétriquement en fonction de la tension Vin, sensiblement linéairement autour d'une valeur moyenne Vm qui est identique pour les trois amplificateurs et qui est obtenue en sortie d'un amplificateur lorsque les tensions sur les deux entrées de cet amplificateur sont égales, les tensions de sortie variant en outre de manière monotone en fonction de Vin pour des valeurs de Vin comprises entre les valeurs extrêmes Vext1 et Vext2, caractérisé en ce que le convertisseur comprend en outre un premier circuit d'interpolation (CIT1) recevant les six tensions de sortie des amplificateurs (ADA, ADB, ADC) et fournissant quatre tensions d'interpolation de rang 1 (V1a, V1b, V'1a, V'1b), variables en fonction de Vin, selon une fonction qui, pour les valeurs de Vin comprises entre les tensions de référence principales, est sensiblement sinusoïdale, identique en amplitude pour les quatre tensions au déphasage près, et représentant une période unique de sinusoïde, les quatre tensions d'interpolation variant en sens inverse deux à deux, deux d'entre elles (V1a,V1b) passant par une valeur moyenne et les deux autres (V'1a,V'1b) présentant l'une un maximum, l'autre un minimum lorsque la tension Vin est égale à l'une quelconque des trois tensions de référence principales.

2. Convertisseur selon la revendication 1, caractérisé en ce qu'un comparateur de rang 0 (CMP0) reçoit les sorties (VBa, VBb) de l'amplificateur différentiel (ADB) relié à la tension de référence principale VR(i) et fournit un bit de poids le plus fort (B0) de la conversion de Vin.

3. Convertisseur selon l'une des revendications précédentes, caractérisé en ce qu'un comparateur de rang 1 (CMP1) reçoit du premier circuit d'interpolation (CIT1) les deux tensions en opposition de phase (V'1a, V'1b) qui passent par un maximum ou un minimum lorsque Vin est égal aux tensions de référence principales VR(i-1), VR(i), VR(i+1), ce comparateur fournissant un bit de rang 1 (B1) de la conversion de Vin.

4. Convertisseur selon l'une des revendications précédentes, caractérisé en ce qu'il comporte au moins un circuit d'interpolation (CITk) de rang k, k>1, recevant quatre tensions issues d'un circuit d'interpolation de rang k-1, et fournissant quatre tensions d'interpolation (Vka, Vkb, V'ka, V'kb) de rang k, variables en fonction de l'amplitude du signal Vin à convertir, selon une fonction qui, pour les valeurs de Vin comprises entre les tensions de référence principales, est sensiblement sinusoïdale, identique en amplitude pour les quatre signaux au déphasage près, et représentant 2^{k-1} périodes de sinusoïde ; les quatre tensions d'interpolation de rang k variant en sens inverse deux à deux; deux d'entre elles (V'ka, V'kb) passant par une valeur moyenne commune lorsque la tension Vin à convertir est égale à des valeurs dites "tensions intermédiaires de rang k", et passent l'une par un maximum l'autre par un minimum lorsque la tension Vin à convertir est égale aux valeurs de tension de référence principales et intermédiaires de rang 1 à k-1; les deux autres tensions d'interpolation de rang k (Vka, Vkb) passant par une valeur moyenne commune lorsque la tension Vin est égale à une tension de référence principale ou intermédiaire de rang 1 à k-1.

5. Convertisseur selon la revendication 4, caractérisé en ce qu'il comporte un comparateur de rang k (CMPk) recevant du circuit d'interpolation de rang k les deux tensions (V'ka, V'kb) en opposition de phase qui passent par un maximum ou un minimum lorsque Vin est égal aux tensions de référence principales ou intermédiaires de rang 1 à k-1, ce comparateur fournissant un bit de rang k de la conversion de Vin.

6. Convertisseur analogique numérique, comportant un convertisseur grossier (CNF) pour l'obtention des bits de poids fort de la conversion, et un convertisseur fin pour l'obtention des bits de poids faibles, caractérisé en ce que le convertisseur fin comprend une structure selon l'une des revendications précédentes.

7. Convertisseur selon la revendication 6, caractérisé en ce que le convertisseur grossier (CNF) est un convertisseur flash utilisant un pont de résistances et N comparateurs, et en ce que le convertisseur fin utilise comme tensions de référence VR(i-1), VR(i), VR(i+1) trois tensions parmi les tensions fournies par ce pont, ces tensions étant sélectionnées par le convertisseur grossier de telle manière que la tension analogique Vin à convertir soit située entre ces trois tensions de référence.

8. Convertisseur selon la revendication 7, caractérisé en ce que le pont de résistances comporte 2N résistances, avec des prises intermédiaires, connectées alternativement aux comparateurs (C(1) à C(N-1)) du convertisseur grossier et aux amplificateurs différentiels (AD(1) à AD(N)) du convertisseur fin.

9. Convertisseur selon la revendication 8, caractérisé en ce qu'il comporte N amplificateurs différentiels (AD(1) à AD(N)) reliés à N prises intermédiaires réparties sur le pont de résistances, les sorties de ces amplificateurs étant connectées, à travers un multiplexeur (MUX) commandé par le convertisseur grossier, aux six entrées du premier circuit d'interpolation (CIT1).

10. Convertisseur selon l'une des revendications précédentes, caractérisé en ce que le ou les circuits d'interpolation comportent chacun, pour chaque groupe de deux tensions d'interpolation à produire, variant symétriquement en sens inverse, une cellule (CL1) à trois paires de branches différentielles, chaque branche comportant au moins une charge et un transistor d'entrée dont l'électrode de commande constitue une entrée de signal pour cette branche; les deux branches symétriques de la première paire sont alimentées par le courant de la première branche de la troisième paire et constituent ensemble la charge de cette première branche ; les deux branches de la deuxième paire sont alimentées par le courant de la deuxième branche de la troisième paire et constituent ensemble la charge de cette deuxième branche ; les premières branches des première et deuxième paire ont une charge commune, les deuxième branches des première et deuxième paires ont également une charge commune symétrique de l'autre.

11. Convertisseur selon la revendication 10, prise en combinaison avec la revendication 3, caractérisé en ce que le circuit d'interpolation de rang k, k>1, comporte deux cellules d'interpolation (CL2, CL'2);
les signaux d'entrée appliqués à la première cellule (CL2) étant :
- deux premiers signaux d'interpolation de rang k-1 (V1a, V1b) )variant en opposition de phase en fonction de Vin, appliqués comme entrées à la première paire différentielle (Q11, Q12),
- ces mêmes signaux, croisés, appliqués à la deuxième paire différentielle (Q21, Q22),
- les deux autres signaux d'interpolation de rang k-1 (V'1b, V'1a) appliqués à la troisième paire différentielle,
et les signaux d'entrée appliqués à la deuxième cellule (CL'2) étant :
- un premier et un deuxième signal d'interpolation de rang k-1(V1a, V'1a) variant en quadrature de phase selon Vin, appliqués aux entrées de la première paire différentielle (Q'11, Q'12),
- les mêmes signaux mais croisés, appliqués aux entrées de la deuxième paire différentielle (Q'21, Q'22),
- un troisième signal d'interpolation de rang k-1 (V1b), variant en opposition de phase avec le premier (V1a), est appliqué à une entrée (Q'31) de la troisième paire différentielle, le deuxième signal d'interpolation de rang k-1 (V'1a) étant appliqué à l'autre entrée (Q'32) de la troisième paire.

12. Convertisseur selon l'une des revendications précédentes, caractérisé en ce que le circuit d'interpolation de rang 1, comporte deux cellules d'interpolation (CL1, CL'1), et en ce que :
la première cellule (CL1) reçoit :
- sur la première paire différentielle (Q11, Q12) les signaux de sortie (VAa, VAb) du premier amplificateur différentiel (ADA), variant en opposition de phase selon Vin, et s'annulant pour Vin égale à la première référence de tension principale VR(i-1) ;
- sur la deuxième paire différentielle (Q21, Q22), les signaux de sortie (Vca, Vcb) du troisième amplificateur (ADC), variant en opposition de phase et s'annulant pour Vin égale à la troisième référence de tension principale VR(i+1);
- sur la troisième paire différentielle (Q31, Q32), les signaux de sortie du second amplificateur (ADB), variant également en opposition de phase et s'annulant pour la deuxième référence de tension VR(i).
et la deuxième cellule (CL'1) reçoit :
- sur la première paire différentielle (Q'11, Q'12) une sortie (VCb) du troisième amplificateur et une sortie (VBa) du deuxième,
- sur la deuxième paire différentielle (Q'21, Q'22) les mêmes signaux mais croisés,
- sur la troisième paire (Q'31, Q'32), d'une part une sortie (VAb) du premier amplificateur et d'autre par une sortie (VBa) du deuxième.

## Patentansprüche

1. Analog/Digital-Umsetzer, der einen Eingang für den Empfang einer umzusetzenden analogen Spannung Vin besitzt und drei Hauptreferenzspannungen VR(i-1), VR(i), VR(i+1) und drei Differenzverstärker (ADA, ADB, ADC) enthält, die jeweils an einem ersten Eingang die umzusetzende Spannung Vin empfangen, welche sich zwischen zwei Extremwerten Vext1 und Vext2, die sich außerhalb des Intervalls zwischen den Hauptreferenzspannungen befinden, verändern kann, wobei die Verstärker an einem zweiten Eingang je eine der drei Hauptreferenzspannungen empfangen, wobei jeder Verstärker zwei Ausgangsspannungen (VAa, VAb; VBa, VBb; VCa, VCb) liefert, die sich in Abhängigkeit von der Spannung Vin symmetrisch, im wesentlichen linear, um einen Mittelwert Vm verändern, der für die drei Verstärker gleich ist und der am Ausgang eines Verstärkers erhalten wird, wenn die Spannungen an den beiden Eingängen dieses Verstärkers gleich sind, wobei sich die Ausgangsspannungen außerdem in monotoner Weise in Abhängigkeit von Vin für Werte von Vin verändern, die zwischen den Extremwerten Vext1 und Vext2 liegen, dadurch gekennzeichnet, daß der Umsetzer außerdem eine erste Interpolationsschaltung (CIT1) enthält, die die sechs Ausgangsspannungen der Verstärker (ADA, ADB, ADC) empfängt und vier Interpolationsspannungen (V1a, V1b, V'1a, V'1b) mit Rang 1 liefert, die in Abhängigkeit von Vin gemäß einer Funktion veränderlich sind, die für die Werte von Vin, die zwischen den Hauptreferenzspannungen liegen, im wesentlichen sinusförmig ist, für die vier Spannungen bis auf eine Phasenverschiebung gleiche Amplitude besitzt und eine einzige Sinusperiode repräsentiert, wobei sich die vier Interpolationsspannungen paarweise in entgegengesetzter Richtung verändern, wobei zwei von ihnen (V1a, V1b) durch einen Mittelwert verlaufen und die beiden anderen (V'1a, V'1b) ein Maximum bzw. ein Minimum aufweisen, wenn die Spannung Vin gleich irgendeiner der drei Hauptreferenzspannungen ist.

2. Umsetzer nach Anspruch 1, dadurch gekennzeichnet, daß ein Komparator (CMP0) mit Rang 0 die Ausgangssignale (VBa, VBb) des Differenzverstärkers (ADB) empfängt, der mit der Hauptreferenzspannung VR(i) verbunden ist, und ein höchstwertiges Bit (B0) der Umsetzung von Vin liefert.

3. Umsetzer nach irgendeinem der vorangehenden Ansprüche, dadurch gekennzeichnet, daß ein Komparator (CMP1) mit Rang 1 von der ersten Interpolationsschaltung (CIT1) die beiden gegenphasigen Spannungen (V'1a, V'1b) empfängt, die durch ein Maximum oder ein Minimum verlaufen, wenn Vin gleich den Hauptreferenzspannungen VR(i-1), VR(i), VR(i+1) ist, wobei dieser Komparator ein Bit (B1) mit Rang 1 der Umsetzung von Vin liefert.

4. Umsetzer nach irgendeinem der vorangehenden Ansprüche, dadurch gekennzeichnet, daß er wenigstens eine Interpolationsschaltung (CITk) mit Rang k, k > 1, enthält, die vier Spannungen empfängt, die von einer Interpolationsschaltung mit Rang k-1 ausgegeben werden, und vier Interpolationsspannungen (Vka, Vkb, V'ka, V'kb) mit Rang k liefert, die von der Amplitude des umzusetzenden Signals Vin gemäß einer Funktion abhängen, die für die Werte von Vin, die zwischen den Hauptreferenzspannungen liegen, im wesentlichen sinusförmig ist, für die vier Signale bis auf eine Phasenverschiebung gleiche Amplitude besitzt und 2^{k-1} Sinusperioden repräsentiert; wobei sich die vier Interpolationsspannungen mit Rang k paarweise in entgegengesetzter Richtung verändern; wobei zwei von ihnen (V'ka, V'kb) durch einen gemeinsamen Mittelwert verlaufen, wenn die umzusetzende Spannung Vin gleich den sogenannten "Zwischenspannungen mit Rang k" ist, und durch ein Maximum bzw. durch ein Minimum verlaufen, wenn die umzusetzende Spannung Vin gleich den Hauptreferenzspannungswerten und den Zwischen-spannungswerten mit Rang 1 bis k-1 ist; wobei die beiden anderen Interpolationsspannungen mit Rang k (Vka, Vkb) durch einen gemeinsamen Mittelwert verlaufen, wenn die Spannung Vin gleich einer Hauptreferenzspannung oder einer Zwischenspannung mit Rang 1 bis k-1 ist.

5. Umsetzer nach Anspruch 4, dadurch gekennzeichnet, daß er einen Komparator (CMPk) mit Rang k enthält, der von der Interpolationsschaltung mit Rang k die beiden Spannungen (V'ka, V'kb) mit entgegengesetzter Phase empfängt, die durch ein Maximum oder ein Minimum verlaufen, wenn Vin gleich den Hauptreferenzspannungen oder den Zwischenspannungen mit Rang 1 bis k-1 ist, wobei dieser Komparator ein Bit mit Rang k der Umsetzung von Vin liefert.

6. Analog/Digital-Umsetzer, mit einem Grobumsetzer (CNF) für die Erlangung der höchstwertigen Bits der Umsetzung und einem Feinumsetzer für die Erlangung der niederwertigeren Bits, dadurch gekennzeichnet, daß der Feinumsetzer eine Struktur nach einem der vorangehenden Ansprüche enthält.

7. Umsetzer nach Anspruch 6, dadurch gekennzeichnet, daß der Grobumsetzer (CNF) ein Flash-Umsetzer ist, der eine Widerstandsbrücke und N Komparatoren verwendet, und daß der Feinumsetzer als Referenzspannungen VR(i-1), VR(i), VR(i+1) drei Spannungen aus den von dieser Brücke gelieferten Spannungen verwendet, wobei diese Spannungen vom Grobumsetzer in der Weise gewählt werden, daß sich die umzusetzende analoge Spannung Vin zwischen diesen drei Referenzspannungen befindet.

8. Umsetzer nach Anspruch 7, dadurch gekennzeichnet, daß die Widerstandsbrücke 2N Widerstände mit Zwischenabgriffen enthält, die abwechselnd an die Komparatoren (C(1) bis C(N-1)) des Grobumsetzers und an die Differenzverstärker (AD(1) bis AD(N)) des Feinumsetzers angeschlossen sind.

9. Umsetzer nach Anspruch 8, dadurch gekennzeichnet, daß er N Differenzverstärker (AD(1) bis AD(N)) enthält, die mit N Zwischenabgriffen verbunden sind, die auf die Widerstandsbrücke verteilt sind, wobei die Ausgänge dieser Verstärker über einen durch den Grobumsetzer gesteuerten Multiplexer (MUX) an sechs Eingänge der ersten Interpolationsschaltung (CIT1) angeschlossen sind.

10. Umsetzer nach irgendeinem der vorangehenden Ansprüche, dadurch gekennzeichnet, daß jede Interpolationsschaltung für jede Gruppe von zwei zu erzeugenden Interpolationsspannungen, die sich symmetrisch in umgekehrter Richtung verändern, eine Zelle (CL1) mit drei Paaren von differentiellen Zweigen enthält, wobei jeder Zweig wenigstens eine Last und einen Eingangstransistor enthält, dessen Steuerelektrode einen Signaleingang für diesen Zweig bildet; die zwei symmetrischen Zweige des ersten Paars durch den Strom des ersten Zweigs des dritten Paars gespeist werden und gemeinsam die Last dieses ersten Zweigs bilden; die zwei Zweige des zweiten Paars durch den Strom des zweiten Zweigs des dritten Paars gespeist werden und gemeinsam die Last dieses zweiten Zweigs bilden; die ersten Zweige des ersten und des zweiten Paars eine gemeinsame Last besitzen und die zweiten Zweige des ersten und des zweiten Paars ebenfalls eine zur anderen symmetrische gemeinsame Last besitzen.

11. Umsetzer nach Anspruch 10 in Kombination mit Anspruch 3, dadurch gekennzeichnet, daß die Interpolationsschaltung mit Rang k, k > 1, zwei Interpolationszellen (CL2, CL'2) enthält;
wobei die an die erste Zelle (CL2) angelegten Eingangssignale:
- zwei erste Interpolationssignale mit Rang k-1 (V1a, V1b) sind, die sich mit entgegengesetzter Phase in Abhängigkeit von Vin verändern und als Eingänge an das erste differentielle Paar (Q11, Q12) angelegt werden,
- dieselben Signale, jedoch gekreuzt, sind, die an das zweite differentielle Paar (Q21, Q22) angelegt werden,
- die beiden anderen Interpolationssignale (V'1b, V'1a) mit Rang k-1 sind, die an das dritte differentielle Paar angelegt werden,
und die an die zweite Zelle (CL'2) angelegten Eingangssignale:
- ein erstes und ein zweites Interpolationssignal (V1a, V'1a) mit Rang k-1 sind, die sich mit einer Phasenverschiebung von 90° gemäß Vin verändern und an die Eingänge des ersten differentiellen Paars (Q'11, Q'12) angelegt werden,
- dieselben Signale, jedoch gekreuzt, sind, die an die Eingänge des zweiten differentiellen Paars (Q'21, Q'22) angelegt werden,
- ein drittes Interpolationssignal (V1b) mit Rang k-1 sind, das sich mit entgegengesetzter Phase gemäß der ersten (V1a) verändert und an einen Eingang (Q'31) des dritten differentiellen Paars angelegt wird, wobei das zweite Interpolationssignal (V'1a) mit Rang k-1 an den anderen Eingang (Q'32) des dritten Paars angelegt wird.

12. Umsetzer nach einem der vorangehenden Ansprüche, dadurch gekennzeichnet, daß die Interpolationsschaltung mit Rang 1 zwei Interpolationszellen (CL1, CL'1) enthält und daß:
die erste Zelle (CL1) empfängt:
- am ersten differentiellen Paar (Q11, Q12) die Ausgangssignale (VAa, VAb) des ersten Differenzverstärkers (ADA), die sich mit entgegengesetzter Phase gemäß Vin verändern und verschwinden, wenn Vin gleich der ersten Hauptspannungsreferenz Vr(i-1) ist;
- am zweiten differentiellen Paar (Q21, Q22) die Ausgangssignale (Vca, Vcb) des dritten Verstärkers (ADC), die sich mit entgegengesetzter Phase verändern und verschwinden, wenn Vin gleich der dritten Hauptspannungsreferenz (VR(i+1)) ist;
- am dritten differentiellen Paar (Q31, Q32) die Ausgangssignale des zweiten Verstärkers (ADB), die sich ebenfalls mit entgegengesetzter Phase verändern und für die zweite Spannungsreferenz VR(i) verschwinden;
und die zweite Zelle (CL'1) empfängt:
- am ersten differentiellen Paar (Q'11, Q'12) ein Ausgangssignal (VCb) des dritten Verstärkers und ein Ausgangssignal (VBa) des zweiten,
- am zweiten differentiellen Paar (Q'21, Q'22) dieselben Signale, jedoch gekreuzt,
- am dritten Paar (Q'31, Q'32) einerseits ein Ausgangssignal (VAb) des ersten Verstärkers und andererseits ein Ausgangssignal (VBa) des zweiten.

## Claims

1. Analogue-digital converter with one input to receive an analogue voltage Vin to be converted, comprising three main reference voltages VR(i-1), VR(i), VR(i+1) and three differential amplifiers (ADA, ADB, ADC), each receiving on a first input, the voltage to be converted Vin variable between two extreme values, Vext**1** and Vext**2** outside the interval between the main reference voltages, each of the amplifiers respectively receiving one of the three main reference voltages on a second input, each amplifier delivering two output voltages (VAa, VAb; VBa, VBb; VCa, VCb) that vary symmetrically as a function of the voltage Vin, almost linearly about an average value Vm that is identical for the three amplifiers and that is obtained as an amplifier output when the voltages on the two inputs of this amplifier are equal, the output voltages moreover varying monotonically as a function of Vin for values of Vin between the extreme values Vext**1** and Vext**2**, characterized in that the converter also includes a first interpolation circuit (CIT1) receiving the six output voltages from the amplifiers (ADA, ADB, ADC) and delivering four rank 1 interpolation voltages (V1a, V1b, V'1a, V'1b), variable as a function of Vin, according to a function that for values of Vin between the main reference voltages is near-sinusoidal, identical in amplitude for the four voltages to within a phase shift, and representing a single sine period, the four interpolation voltages varying inversely in pairs, two of them (V1a, V1b) passing through an average value and the other two (V'1a, V'1b) exhibiting the one a maximum and the other a minimum when the voltage Vin is equal to any one of the three main reference voltages.

2. Converter according to Claim 1, characterized in that a rank 0 comparator (CMPO) receives the outputs (VBa, VBb) from the differential amplifier (ADB) connected to the main reference voltage VR(i) and delivers a high order bit (BO) of the conversion of Vin.

3. Converter according to any one of claims 1 or 2, characterized in that a rank 1 comparator (CMP1) receives the two voltages in phase opposition (V'1*a*, V'1*b*) from the first interpolation circuit (CIT1), that pass through a maximum or a minimum when Vin is equal to the main reference voltages VR(i-1), VR(i), VR(i+1), this comparator delivering a rank 1 bit (B1) of the conversion of Vin.

4. Converter according to any one of the preceding claims, characterized in that it comprises at least one rank k, k>1, interpolation circuit (CITk) receiving four voltages output from a rank k-1 interpolation circuit, and delivering four rank k interpolation voltages (Vka, Vkb, V'ka, V'kb), variable as a function of the amplitude of the signal Vin to be converted, according to a function that, for values of Vin between the main reference voltages, is near-sinusoidal, identical in amplitude for the four signals to within a phase shift, and representing 2^{k-1} sine periods; the four rank k interpolation voltages varying inversely in pairs; two of them (V'ka, V'kb) passing through a common average value when the voltage Vin to be converted is equal to so-called "rank k intermediate voltages" values, and one of them passing through a maximum and the other through a minimum when the voltage Vin to be converted is equal to the main reference voltage and intermediate voltage values of rank 1 to k-1; the other two rank k interpolation voltages (Vka, Vkb) passing through a common average value when the voltage Vin is equal to a main reference voltage or a rank 1 to k-1 intermediate voltage.

5. Converter according to claim 4, characterized in that it comprises a rank k comparator (CMPk) receiving the two voltages (V'ka, V'kb) from the rank k interpolation circuit in phase opposition, which pass through a maximum or a minimum when Vin is equal to the main reference voltages or rank 1 to k-1 intermediate voltages, this comparator delivering a rank k bit of the conversion of Vin.

6. Analogue-digital converter, icluding a coarse converter (CNF) for obtaining high order bits of the conversion, and a fine converter for obtaining low order bits, characterized in that the fine converter includes a structure according to any one of the preceding claims.

7. Converter according to claim 6, characterized in that the coarse converter (CNF) is a flash converter using a resistance bridge and N comparators, and the fine converter uses three of the voltages supplied by this bridge as reference voltages VR(i-1), VR(i), VR(i+1), these voltages being selected by the coarse converter such that the analogue voltage Vin to be converted is located between these three reference voltages.

8. Converter according to claim 7, characterized in that the resistance bridge comprises 2N resistances with intermediate taps connected alternately to the coarse converter comparators (C(1) to C(N-1)) and to the differential amplifiers (AD(1) to AD(N)) of the fine converter.

9. Converter according to claim 8, characterized in that it contains N differential amplifiers (AD(1) to AD(N)) connected to N intermediate taps distributed on the resistance bridge, the outputs of these amplifiers being connected, through a multiplexer (MUX) controlled by the coarse converter, to the six inputs of the first interpolation circuit (CIT1).

10. Converter according to one of the preceding claims, characterized in that, for each group of two interpolation voltages to be produced, varying symmetrically and inversely, the interpolation circuit(s) each comprise one cell (CL1) with three pairs of differential branches, each branch including at least one load and an input transistor for which the control electrode forms a signal input for this branch; the two symmetric branches of the first pair are powered by the current from the first branch of the third pair and together form the load for this first branch; the two branches of the second pair are powered by the current in the second branch of the third pair and together form the load for the second branch; the first branches of the first and second pairs have a common load, the second branches of the first and second pairs also have a common load symmetric with the other load.

11. Converter according to claim 10, taken in combination with Claim 3, characterized in that the rank k, k>1, interpolation circuit, contains two interpolation cells (CL2, CL'2), with
the input signals applied to the first cell (CL2) being:
- two first rank k-1 interpolation signals (V1a, V1b) varying in phase opposition as a function of Vin, applied as inputs to the first differential pair (Q11, Q12),
- these same signals, crossed, applied to the second differential pair (Q21, Q22),
- the other two rank k-1 interpolation signals (V'1b, V'1a) applied to the third differential pair,
and the input signals applied to the second cell (CL'2) being:
- a first and second rank k-1 interpolation signal (V1a, V'1a) varying 90° out of phase with Vin, applied to the inputs of the first differential pair (Q'11, Q'12),
- the same signals but crossed, applied to the inputs of the second differential pair (Q'21, Q'22),
- a third rank k-1 interpolation signal (V1b) varying in phase opposition with the first (V1a), is applied to an input (Q'31) of the third differential pair, the second rank k-1 interpolation signal (V'1a) being applied to the other input (Q'32) of the third pair.

12. Converter according to one of the preceding claims, characterized in that the rank 1 interpolation circuit includes two interpolation cells (CL1, CL'1) and in that:
the first cell (CL1) receives:
- on the first differential pair (Q11, Q12), the output signals (VAa, VAb) from the first differential amplifier (ADA), varying in phase opposition with Vin, and vanishing when Vin is equal to the first main reference voltage VR(i-1);
- on the second differential pair (Q21, Q22), the output signals (Vca, Vcb) from the third amplifier (ADC), varying in phase opposition and cancelling out when Vin is equal to the third main reference voltage VR(i+1);
- on the third differential pair (Q31, Q32), the output signals from the second amplifier (ADB) also varying in phase opposition and cancelling out for the second voltage reference VR(i).
and the second cell (CL'1) receives:
- on the first differential pair (Q'11, Q'12), an output (VCb) from the third amplifier and an output (VBa) from the second,
- on the second differential pair (Q'21, Q'22), the same signals but crossed,
- on the third pair (Q'31), Q'32), on the one hand an output (VAb) from the first amplifier and on the other hand an output (VBa) from the second.
